# EUROPEAN PATENT APPLICATION

(11) **EP 4 629 296 A1**
(43) Date of publication of application: **08.10.2025**
(21) Application number: 23897212.9
(22) Date of filing: 19.09.2023
(51) Int. Cl.: H01L 33/20, H01L 33/30, H01L 33/36

(54) **MICRO-LED ELEMENT**

(30) Priority: 29.11.2022 JP 2022189962
(71) Applicant: Shin-Etsu Handotai Co., Ltd., Tokyo 100-0004 (JP)
(72) Inventor: ISHIZAKI Junya, Annaka-shi, Gunma 379-0196 (JP)
(74) Representative: Röthinger, Rainer
(86) International application number: PCT/JP2023/033849
(87) International publication number: WO 2024/116553

(57) **Abstract**

The present invention is a micro-LED device characterized by having one side less than 100 µm and a light-emitting device structure with an active layer included of (Al_{y}Ga_{1-y})ₓIn₁₋ₓP (0.4≤x≤0.6, 0≤y≤0.5) sandwiched between a first cladding and a second cladding; and having an upper electrode; and a lower electrode of opposite polarity to the upper electrode; and being a micro-LED device wherein the light-emitting device structure, the upper electrode, and the lower electrode are placed on a first surface of the micro-LED device; the upper electrode is placed on an upper surface of the light-emitting device structure; the lower electrode is placed in a location where the light-emitting device structure is not present; and the light-emitting device structure is placed so that it surrounds the lower electrode. This provides a micro-LED device that can reduce or avoid cracking of micro-LED devices (dices) that have one side less than 100 µm, and have an AlGaInP-based light-emitting device structure and two electrodes of opposite polarity on the same surface.

## Description

### TECHNICAL FIELD

The present invention relates to a micro-LED device. In particular, it relates to a structure for a micro-LED device that can reduce or avoid cracking.

### BACKGROUND ART

An art to realize micro-LED displays is disclosed in Patent Document 1, where LEDs are separated from starting substrates using laser lift-off (LLO) and the LEDs are transferred to a mounting substrate, followed by transfer to a drive substrate. However, everything there relates only to GaN-based LEDs, and few arts have been disclosed that relate to micro-LED devices that use AlGaInP-based LEDs.

In order to realize a micro-LED device with an AlGaInP-based LED by an LLO step, transfer to a sapphire substrate is required. With regard to arts to transfer an AlGaInP-based LED to a sapphire substrate, prior arts such as Patent Document 7 have been disclosed.

However, AlGaInP-based LEDs are mechanically fragile compared to GaN-based LEDs, and dice cracking can easily occur during the LLO step depending on the suitability of a dice design. No art has been disclosed regarding avoiding micro-LED dice cracking during the LLO step. In particular, no prior art has been disclosed regarding dice design and cracking.

In Patent Document 2, a design has been disclosed in which a rectangular ohmic electrode is placed at a long side direction end part of a chip that have a long side and a short side. This is a typical chip design, but it does not take dice cracking into consideration, and since a lower electrode and an upper electrode are formed separately (in different batches), it is difficult to make their heights match absolutely. Due to a difference in heights, stress gets applied to a region between the upper electrode and the lower electrode during LLO. If the base part connecting the upper electrode region and the lower electrode region is mechanically weak, this can lead to dice cracking. In AlGaInP-based LEDs, the part that corresponds to a base is generally made from GaP that has a high density of crystal dislocations, and a mechanical strength is extremely low.

In Patent Document 3, a structure is disclosed in which three directions of the lower electrode are surrounded by a DH layer (light-emitting layer). With this structure, since the lower electrode and the upper electrode are formed separately (in different batches), it is difficult to make their heights match absolutely. Therefore, as in the case of Patent Document 2, dice cracking can easily occur in the art shown in Patent Document 3. Therefore, the art disclosed in Patent Document 3 is not an art to increase a mechanical strength of a dice.

For an art similar to Patent Document 3, in Patent Document 4, a design has been disclosed in which the lower electrode has a long side and the upper electrode surrounds three sides of the lower electrode. However, one side of the lower electrode is not surrounded, and the lower electrode is extended in a direction in which it is not surrounded. Furthermore, an upper part is open, and a device is partially thin at an opening part. Therefore, a mechanical strength of the lower electrode at the opening part is low. Usually, a side of a dice are formed along a <100> direction, i.e., a cleavage direction, so its structure is easy to cleave. Therefore, the configuration in Patent Document 4, in which one side is not surrounded, is not a suitable art in terms of avoiding dice cracking.

In Patent Document 5, a design is disclosed in which a plurality of circular lower electrodes are surrounded in a GaN-based LED. On the other hand, in a micro-LED device, one side of the dice is generally less than 100 µm, and in many cases, a long sides of the lower electrode is around 50 µm or less and a short side is about half that. If the design in Patent Document 5 is to be applied to an AlGaInP-based LED, it will be necessary to shave down an AlGaInP-based light-emitting layer, which is around 2 to 3 µm thick, and to provide a plurality of electrodes. Since an active layer will be exposed during a process of shaving down the AlGaInP-based light-emitting layer, a passivation film will need to be formed on a processed cross-section surface in order to prevent short circuits. Therefore, an area where ohmic contact is possible will be smaller than a diameter of an opened hole. The fact that an area of a contact electrode will be smaller than an opening processing area will not be a major problem for dices that are not micro-LED-device-sized but larger. However, with minute dices such as micro-LED devices, space efficiency will be poor. Furthermore, in the prior art, an electrode part that is in contact with a plurality of lower electrodes is provided in a separate space, and that design also worsens space efficiency. In Patent Document 5, although there is no clear indication of dice size, it is clear that the art is not suitable for designing small dices such as micro-LED devices.

In Patent Document 6, a structure is disclosed in which two directions of the lower electrode are surrounded by a DH layer (light-emitting layer). The processed structure of the DH layer in Patent Document 6 is for the object of brightness improvement and interconnection, and it is an example of a size that exceeds 100 µm on one side. It is not a disclosure of an art that bears in mind cracking of micro-LED devices that are less than 100 µm even on their long sides.

As shown above, no art has been disclosed that avoids dice cracking during the LLO step in micro-LED devices that have an AlGaInP-based material for their active layer.

### CITATION LIST

### PATENT LITERATURE

Patent Document 1: JP 2020-521181 A
Patent Document 2: JP 2019-129299 A
Patent Document 3: JP 2014-179590 A
Patent Document 4: JP 2011-124248 A
Patent Document 5: JP 2009-117796 A
Patent Document 6: WO 2010/074288 A1
Patent Document 7: JP 2022-013203 A

### SUMMARY OF INVENTION

### TECHNICAL PROBLEM

The present invention has been made in view of the above-described problem. An object of the present invention is to provide a micro-LED device that can reduce or avoid cracking of micro-LED devices (dices) that have one side less than 100 µm, and have an AlGaInP-based light-emitting device structure and two electrodes of opposite polarity on the same surface.

### SOLUTION TO PROBLEM

To achieve the object, the present invention provides a micro-LED device having:
one side less than 100 µm; and
a light-emitting device structure with an active layer comprised of (Al_{y}Ga_{1-y})ₓIn₁₋ₓP (0.4≤x≤0.6, 0≤y≤0.5) sandwiched between a first cladding and a second cladding; and having:
   an upper electrode; and
   a lower electrode of opposite polarity to the upper electrode; and being a micro-LED device wherein:
      the light-emitting device structure, the upper electrode, and the lower electrode are placed on a first surface of the micro-LED device;
      the upper electrode is placed on an upper surface of the light-emitting device structure;
      the lower electrode is placed in a location where the light-emitting device structure is not present; and
      the light-emitting device structure is placed so that it surrounds the lower electrode.

With conventional micro-LED device structures, there is a difference in level between the upper electrode and the lower electrode, and this makes it easy for stress concentration points to form. However, with the micro-LED device in the present invention, by having the light-emitting device structure surround the lower electrode, a difference in level in the upper electrode and a part surrounding the lower electrode can be reduced, and parts that would become stress concentration points have the light-emitting device structure in them. This makes a strength decrease less likely. Therefore, it can reduce a frequency of dice cracking.

Furthermore, it is preferable that the light-emitting device structure surrounding the lower electrode either does so continuously without any breaks, or has a cutout, and a boundary part between the cutout and an outer side of the light-emitting device structure is located outside an end part of the lower electrode.

If the light-emitting device structure surrounds the lower electrode continuously without any breaks, there will be no difference in level around the lower electrode. This will make a strength decrease the least likely. Moreover, even if the light-emitting device structure has a cutout, as long as a boundary part between the cutout and an outer side of the light-emitting device structure is located outside an end part of the lower electrode, a strength decrease can be prevented sufficiently. By preventing the strength decrease in this way, the frequency of dice cracking can be reduced.

In addition, it is preferable that a transparent wafer to an emission wavelength is bonded to a second surface of the micro-LED device with an adhesive or a bonding material.

If an LLO (laser lift-off) step is performed with such a bonded wafer, conventionally, it is a step with a high frequency of cracking. However, the present invention enables the frequency of dice cracking to be reduced.

In addition, the adhesive or the bonding material is preferably BCB.

Such an adhesive or a bonding material can be suitably applied to the micro-LED device.

In addition, the transparent wafer is preferably made of sapphire or quartz.

Such a transparent wafer can be suitably applied to the micro-LED device.

### ADVANTAGEOUS EFFECTS OF INVENTION

As described above, with the micro-LED device in the present invention, by having the light-emitting device structure surround the lower electrode, a difference in level in the upper electrode and a part surrounding the lower electrode can be reduced, and parts that would become stress concentration points have the light-emitting device structure in them. This makes a strength decrease less likely. Therefore, it can reduce a frequency of dice cracking.

### BRIEF DESCRIPTION OF DRAWINGS

FIG. 1 is a schematic cross-sectional view illustrating one step of a method for manufacturing a micro-LED device of the first embodiment according to the present invention.
FIG. 2 is a schematic cross-sectional view illustrating one step of a method for manufacturing a micro-LED device of the first embodiment according to the present invention.
FIG. 3 is a schematic cross-sectional view illustrating one step of a method for manufacturing a micro-LED device of the first embodiment according to the present invention.
FIG. 4 is a schematic cross-sectional view illustrating one step of a method for manufacturing a micro-LED device of the first embodiment according to the present invention.
FIG. 5 is a schematic cross-sectional view illustrating one step of a method for manufacturing a micro-LED device of the first embodiment according to the present invention.
FIG. 6 is a schematic cross-sectional view illustrating one step of a method for manufacturing a micro-LED device of the first embodiment according to the present invention.
FIG. 7 is a schematic cross-sectional view illustrating one example of a transfer method for a micro-LED device of the first embodiment according to the present invention.
FIG. 8 is a top view of a micro-LED device of the first embodiment according to the present invention.
FIG. 9 is a cross-sectional view of a micro-LED device of the first embodiment according to the present invention.
FIG. 10 is a top view of a micro-LED device of the second embodiment of the present invention.
FIG. 11 is a cross-sectional view of a micro-LED device of the second embodiment according to the present invention.
FIG. 12 is a cross-sectional view of a micro-LED device of the second embodiment according to the present invention.
FIG. 13 is a cross-sectional view of a micro-LED device of the second embodiment according to the present invention.
FIG. 14 is a top view of another example of a micro-LED device of the second embodiment according to the present invention.
FIG. 15 is a top view of a conventional micro-LED device.
FIG. 16 is a cross-sectional view of a conventional micro-LED device.

### DESCRIPTION OF EMBODIMENTS

As described above, it was found that no art has been disclosed that avoids dice cracking during the LLO step for micro-LED devices that have one side less than 100 µm, and have an AlGaInP-based light-emitting device structure and two electrodes of opposite polarity on the same surface.

Investigating further, the present inventors found that, in the above-described micro-LED devices, by having the light-emitting device structure surround the lower electrode, the difference in level in the upper electrode and a part surrounding the lower electrode can be reduced, so a strength decrease can be made less likely, which means the frequency of dice cracking can be reduced. This led them to complete the present invention.

That is, the present invention is a micro-LED device having:
one side less than 100 µm; and
a light-emitting device structure with an active layer comprised of (Al_{y}Ga_{1-y})ₓIn₁₋ₓP (0.4≤x≤0.6, 0≤y≤0.5) sandwiched between a first cladding and a second cladding; and having:
   an upper electrode; and
   a lower electrode of opposite polarity to the upper electrode; and being a micro-LED device wherein:
      the light-emitting device structure, the upper electrode, and the lower electrode are placed on a first surface of the micro-LED device;
      the upper electrode is placed on an upper surface of the light-emitting device structure;
      the lower electrode is placed in a location where the light-emitting device structure is not present; and
      the light-emitting device structure is placed so that it surrounds the lower electrode. Regarding a lower limit for one side of the micro-LED device, there is no restriction in particular, but it can be set to, e.g., 1 µm or more.

Hereinafter, the present invention will be described in detail. However, the present invention is not limited thereto.

### (First embodiment)

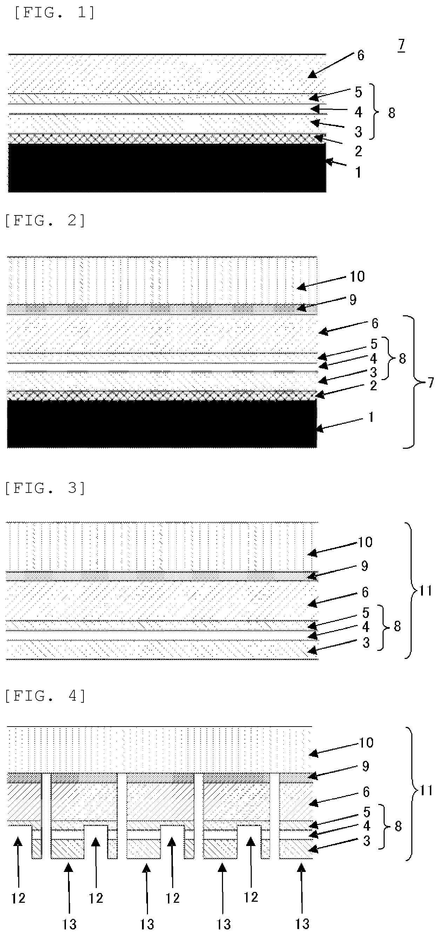

First, as shown in FIG. 1, after stacking a first conductivity-type GaAs buffer layer on a first conductivity-type GaAs starting substrate 1, an epitaxial wafer 7 with a light emitting device structure is provided as an epitaxial functional layer in which the following were sequentially grown: as an etching stop layer 2 a first conductivity-type GaₓIn₁₋ₓP (0.4≤x≤0.6) first etching stop layer of, e.g., 0.1 µm thickness; a first conductivity-type GaAs second etching stop layer of, e.g., 0.1 µm thickness; followed by a first conductivity-type (Al_{y}Ga_{1-y})ₓIn₁₋ₓP (0.4≤x≤0.6, 0.6≤y≤1.0) first cladding layer (first cladding 3) of, e.g., 1.0 µm thickness; a non-doped (Al_{y}Ga_{1-y})ₓIn₁₋ₓP (0.4≤x≤0.6, 0≤y≤0.5) active layer 4; a second conductivity-type (Al_{y}Ga_{1-y})ₓIn₁₋ₓP (0.4≤x≤0.6, 0.6≤y≤1.0) second cladding layer (second cladding 5) of, e.g., 1.0 µm thickness; a second conductivity-type GaₓIn₁₋ₓP (0.5≤x≤1.0) intermediate layer of, e.g., 0.1 µm thickness; and a second conductivity-type GaP window layer 6. At this point, the layers from the first cladding layer 3 to the second cladding layer 5 are referred to as a double-hetero (DH) structure part (DH layer 8, or light-emitting device structure 8).

The film thicknesses shown above are just examples, and the film thickness is no more than a parameter to be changed according to the operating specifications of the device; therefore, the film thickness is not limited to the thickness described here. Furthermore, the case where both the first cladding layer and the second cladding layer have a thickness of 1.0 µm is shown as an example, but a rated current density of the micro-LED device is smaller than that of a discrete LED device of larger size, and even with a thinner film thickness, a function as a cladding layer will not be compromised.

As described later, the electrodes are formed in contact with the first cladding layer 3; thus, taking into consideration metal diffusion during ohmic contact formation, it is suitable that the first cladding layer 3 has a thickness of 0.6 µm or more. Any thickness can be selected as long as it is at least as thick as this. However, if it is too thick, then in addition to increasing the costs, it can also easily lead to issues such as decreased light-emission efficiency during constant-current driving, or decreased yield due to significant warping of the wafer. Therefore, it is preferable to design it to be in the range of 10 µm or less.

When the second conductivity-type is p-type, an effective mass of a hole is large, allowing the second cladding layer 5 to function the same as it had a thickness of 1.0 µm even if it has a thickness of, for example, about 0.2 µm. Therefore, any thickness can be selected as long as it is 0.2 µm or more. However, if it is too thick, then in addition to increasing the costs, it can also easily lead to issues such as decreased light-emission efficiency during constant-current driving, or decreased yield due to significant warping of the wafer. Therefore, it is preferable to design it to be in the range of 10 µm or less.

Furthermore, each layer does not have to be a single composition layer, but may have a layer of a plurality of compositions within a range of compositions shown in the example.

Furthermore, levels of carrier concentrations do not have to be uniform in each layer, but may have a plurality of levels in each layer.

The active layer 4 may be composed of a single composition or may have a super-lattice structure where a plurality of barrier layers and active layers are alternatively stacked. Both will function similarly, and either of them can be selected. Regardless of which structure is selected, the functions and effects of the present art will be the same.

The thickness of the GaP window layer 6 needs to be over 5 µm, and can be, for example, about 6 µm. However, it is not limited to this thickness. Any thickness can be selected as long as it is thinner than a short side length at a device isolation described later.

Next, as shown in FIG. 2, benzocyclobutene (BCB) is spin-coated onto the epitaxial wafer 7 as a thermosetting bonding material (hereinafter, bonding material 9). Then, the epitaxial wafer 7 is stacked facing the to-be-bonded wafer, i.e., the sapphire wafer 10 (transparent wafer 10), and bonded to it by thermal compression under a vacuum atmosphere. When BCB is coated on by spin coating, a designed film thickness can be, for example, 0.6 µm.

Furthermore, the atmosphere is not limited to a vacuum atmosphere, and any atmosphere can be adopted as long as an atmosphere with an oxygen concentration of 100 ppm or less can be created. The same effects can be obtained with a nitrogen or argon atmosphere.

Furthermore, the to-be-bonded substrate is not limited to sapphire, and any material can be selected as long as transparency to an LLO laser light and flatness are guaranteed. In addition to sapphire, quartz can also be selected.

Furthermore, BCB is not limited to being applied in a layer shape. The same results can be obtained by using photosensitive BCB, patterning it into an isolated island shape, a line shape, or some other shape, and then performing the bonding step.

Moreover, the thickness of the BCB is not limited to 0.6 µm, and the same effects can be obtained even it is thinner.

Next, as shown in FIG. 3, the GaAs starting substrate is removed by wet etching to expose the first etching stop layer, and the first and the second etching stop layers are then removed with appropriate etchants to expose the first cladding layer 3, thereby producing an epitaxial bonded substrate 11 that retains only the DH layer 8 and the GaP window layer 6.

Next, as shown in FIG. 4, a SiO₂ film is formed to a thickness of, for example, 1 µm on the epitaxial layer of an epitaxial bonded substrate 11 by a P-CVD method using TEOS and O₂ as materials. Next, a resist pattern is formed by photolithography (hereinafter, photolitho method), and a pattern shape of SiO₂ is made with a hydrofluoric acid solution. Note that this SiO₂ pattern shape is to have one side less than 100 µm. Next, using the SiO₂ pattern as a hard mask, ICP treatment is performed with an ICP apparatus into which chlorine-based gas has been introduced, and the DH layer 8 and the GaP window layer 6 are dry etched to expose the BCB layer (bonding material 9). Then, the etching gas is switched and the exposed BCB layer (bonding material 9) is further dry etched to expose the sapphire wafer (transparent wafer 10), and a device isolation pattern consisting of the DH layer 8 and the GaP window layer 6 is formed. After forming the device isolation pattern, a SiO₂ pattern is formed so that part of the device isolation pattern is open. Part of the DH layer 8 is etched by the ICP method in the same manner as above to expose the second cladding layer 5, the intermediate layer, or the GaP window layer 6. Then, processing is performed to provide it with a bathtub-shaped processed part 12.

Although the bathtub-shaped processed part 12 shown in FIG. 4 has vertical walls, the walls are not limited to being vertical. Depending on the ICP processing conditions, a slope of about 10 to 15 degrees can easily be formed, and it may also be a sloped shape.

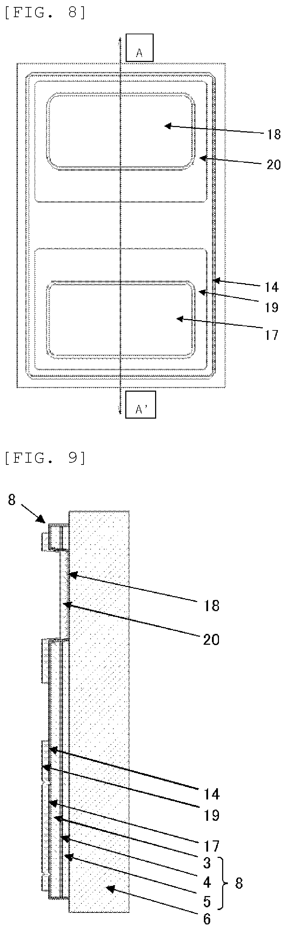

Furthermore, the bathtub-shaped processed part 12 is not limited to a substantially rectangular shape as shown in FIG. 8, but may also be shapes such as elliptical, circular, and polygonal. Thus, by forming the bathtub-shaped processed part 12, the perimeter of the device (dice 13) is surrounded by the light-emitting device structure 8, and parts that would become stress concentration points have the light-emitting device structure 8 in them. This makes a strength decrease less likely. Therefore, the frequency of cracking of the dice 13 will decrease.

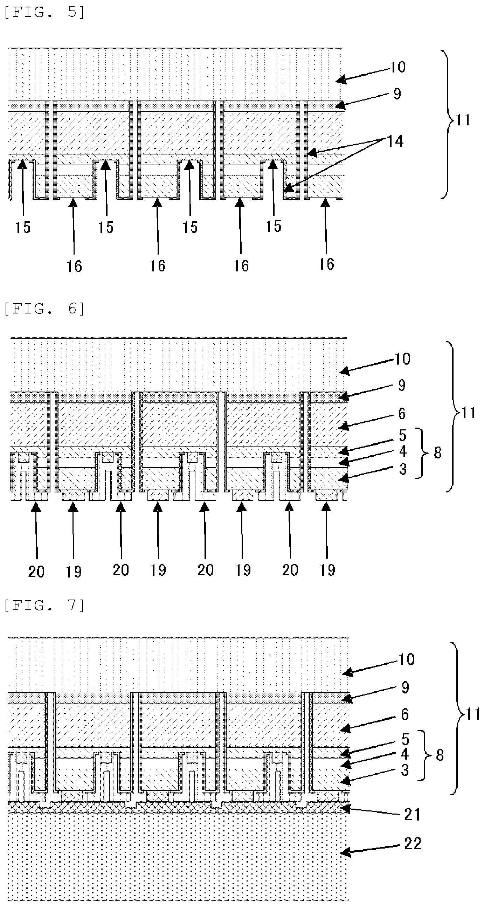

Next, as shown in FIG. 5, an entire surface is coated with a SiO₂ layer of thickness, for example, 0.1 µm by a P-CVD method using TEOS and O₂ as materials, to form an insulating film 14. The method is not limited to a P-CVD method, and other film forming methods such as sputtering methods, photo-CVD, EB evaporation, and PLD methods may also be used.

Next, a resist pattern is formed by a photolitho method so that both a bottom of the bathtub-shaped processed part 12, i.e., the second contact part 15 (opening part 15), and part of the first cladding layer 3, i.e., the first contact part 16 (opening part 16), are open, and opening parts are formed by wet etching using a hydrofluoric acid-based etchant. The opening parts 15 and 16 are the bottom of the bathtub-shaped processed part, i.e., the second contact part, and the first contact part where part of the first cladding layer is exposed.

Next, after the opening processing, a first contact electrode (first ohmic electrode 17) is formed at the first contact part 16, and a second contact electrode (second ohmic electrode 18) is formed at the second contact part 15 (see FIG. 8). When the first conductivity-type is p-type, the first contact electrode is formed with a metal containing AuZn or AuBe, and the second contact electrode is formed with a metal containing AuGe or AuSi. When the first conductivity-type is n-type, the first contact electrode is formed with a metal containing AuGe or AuSi, and the second contact electrode is formed with a metal containing AuZn or AuBe. The film thickness may be formed to be, for example, 0.1 µm, i.e., substantially the same as that of the SiO₂ insulating film 14.

Note that the thickness of each contact electrode is not limited to 0.1 µm. The same effects can be obtained whether the film thickness is thicker or thinner than this, but if it is too thin, there is a risk that the ohmic nature will be reduced. To prevent this, it is suitable that the thickness is 0.05 µm or more. In the present art, the key point is to make the thickness of the contact electrodes and SiO₂ insulating film 14 substantially the same. Therefore, if the SiO₂ insulating film 14 is too thin, a coverage rate on the processed-side surface will decrease, and electrical leakage may occur there. For this reason, it is not good if the SiO₂ insulating film 14 is too thin. Therefore, the film thickness is preferably 0.05 µm or more. Moreover, if the contact electrodes are too thick, the effects of the present art will be reduced when pad electrodes described later are formed. Therefore, the thickness of the contact electrode should preferably be 1/5 or less of that of the pad electrode described later. The pad electrodes will generally not exceed 3 µm in thickness. Therefore, the contact electrodes are preferably 0.6 µm or less.

Next, as shown in FIG. 6, after the contact electrodes are formed, pad electrodes 19 and 20 are formed in such a way that they are in contact with at least part of each contact electrode and each electrodes are separated electrically. The thickness of the pad electrodes is preferably five times or more that of the contact electrodes, particularly that of the contact electrode in contact with the first cladding layer 3. The pad electrodes can be film-formed by, for example, a vacuum deposition method. Furthermore, this will mitigate the unevenness (height difference) between the SiO₂ insulating film and the contact electrode surfaces, which were assumed to be substantially the same by making the thickness of the pad electrode more than five times that of the contact electrode, or more than 0.25 µm. Therefore, stress concentration during the LLO step can be reduced or avoided. FIG. 8 shows a top view after the formation of the pad electrodes 19 and 20, and has been included to clarify the relationship between the first contact electrode (first ohmic electrode 17) and the second contact electrode (second ohmic electrode 18). Furthermore, FIG. 9 shows a cross-sectional view along the line A-A' in FIG. 8.

Next, as shown in FIG. 7, a micro-LED device pattern is pressed against a quartz substrate (transfer substrate 22) that has a silicone convex pattern (silicone layer 21) similar to the micro-LED device pattern and pitch, and an excimer laser is shone on from the sapphire substrate side to sublimate the BCB. By sublimating the BCB, the LLO step is performed to separate the micro-LED device from the sapphire, and it is transferred from the sapphire substrate to the quartz substrate.

As described above, the micro-LED device of this embodiment is one having:
one side less than 100 µm; and
a light-emitting device structure 8 with an active layer 4 comprised of (Al_{y}Ga_{1-y})ₓIn₁₋ₓP (0.4≤x≤0.6, 0≤y≤0.5) sandwiched between a first cladding 3 and second cladding 5; and having:
an upper electrode 17 (first contact electrode, first ohmic electrode); and
a lower electrode 18 (second contact electrode, second ohmic electrode) of opposite polarity to the upper electrode; and being a micro-LED device wherein:
   the light-emitting device structure 8, the upper electrode 17, and the lower electrode 18 are placed on a first surface of the micro-LED device;
   the upper electrode 17 is placed on an upper surface of the light-emitting device structure 8;
   the lower electrode 18 is placed in a location where the light-emitting device structure 8 is not present; and
   the light-emitting device structure 8 is placed so that it surrounds the lower electrode 18.

With conventional micro-LED device structures, there is a difference in level between the upper electrode and the lower electrode, and this makes it easy for stress concentration points to form. However, with the micro-LED device in the present invention, as is also clear from the configurations in FIG. 8 and FIG. 9, by having the light-emitting device structure surround the lower electrode 18, the parts that would become stress concentration points have the light-emitting device structure 8 in them. This makes a strength decrease less likely. Therefore, it can reduce the frequency of dice cracking.

Furthermore, in the first embodiment, the light-emitting device structure 8 that surrounds a periphery of the lower electrode 18 surrounds it continuously without any breaks.

If the light-emitting device structure 8 surrounds the periphery of the lower electrode 18 continuously without any breaks, there will be no difference in level in the upper electrode 17 and a part surrounding the lower electrode 18. This will make a strength decrease the least likely. By preventing a strength decrease in this way, the frequency of dice cracking can be reduced.

In addition, a transparent wafer (sapphire wafer 10) to the emission wavelength and a laser light for an LLO transfer is bonded to the second surface of the micro-LED device using BCB (bonding material 9), which is transparent to the emission wavelength and absorbs the laser light for the LLO transfer. If an LLO (laser lift-off) step is performed with such a bonded wafer, conventionally, it is a step with a high frequency of cracking. However, the present invention enables the frequency of dice cracking to be reduced.

Moreover, although BCB has been used for the bonding material 9, it is not limited to BCB, and a similar adhesive or a similar bonding material may also be used.

Moreover, although sapphire has been used for the transparent wafer 10, it is not limited to sapphire. Quartz may also be used, and any material can be selected as long as transparency to an LLO laser light and flatness are guaranteed.

### (Second embodiment)

In the second embodiment, a processing step is performed to provide a bathtub-shaped processed part where a second conductivity-type layer such as the second cladding layer, the GaInP intermediate layer, or the GaP window layer is exposed, and in this respect, it is the same as the first embodiment. However, it differs from the first embodiment in that the cutout is provided in the directions of corners of the device isolation pattern.

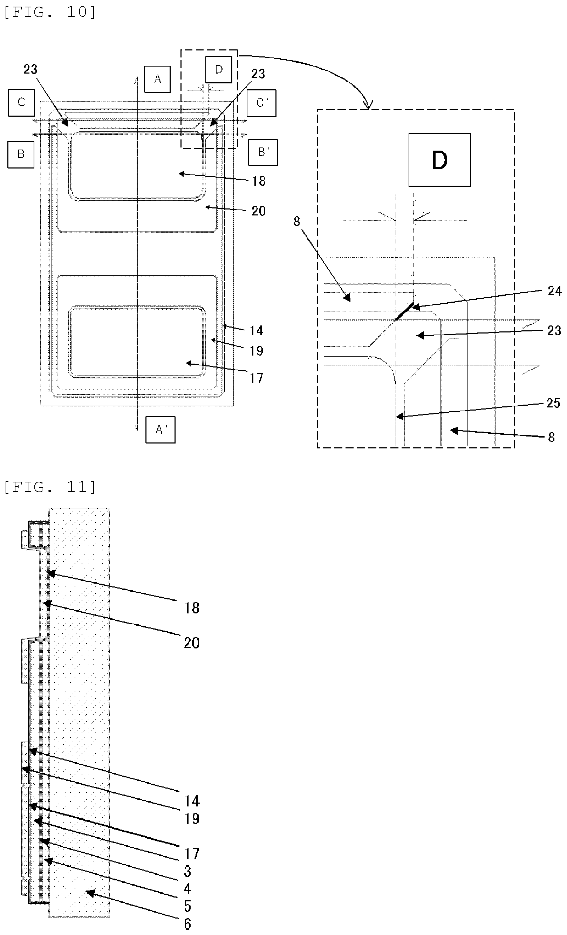

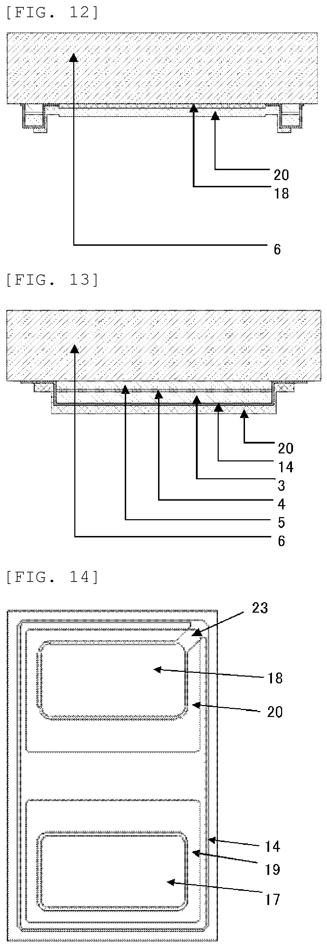

In some cases, the corner cutout 23 can be two parts as shown in FIG. 10, and in some cases, it can be one part as shown in FIG. 14. Furthermore, FIG. 11 shows a cross-sectional view along the line A-A' in FIG. 10. A cross-sectional view of FIG. 14 has been omitted, since it would be the same as FIG. 11.

In FIG. 10, the boundary part 24 between the corner cutout 23 and the outer side of the light-emitting device structure 8 is arranged so as not to be inside the end part 25 of the lower electrode (the end part of the second contact electrode (second ohmic electrode 18)). That is, the length D in FIG. 10 is to be D≥0. With such a structure, parts that would become stress concentration points have the light-emitting device structure 8 in them, and stress is prevented from being applied to the lower electrode (second contact electrode (second ohmic electrode 18)), which is a thin part of the device (dice). This makes a strength decrease less likely. Therefore, the frequency of dice cracking will decrease.

Furthermore, FIG. 12 shows a cross-sectional view along the line B-B' in FIG. 10, and FIG. 13 shows a cross-sectional view along the line C-C' in FIG. 10. It can be understood that by placing the light-emitting device structure 8 at both ends of FIG. 12 and in the center of FIG. 13, stress is less likely to be applied to the lower electrode (second contact electrode (second ohmic electrode 18)).

As described above, in the present embodiment, the light-emitting device structure 8 surrounding the periphery of the lower electrode (second contact electrode (second ohmic electrode 18)) has a cutout 23, and the boundary part 24 between the cutout 23 and the outer side of the light-emitting device structure 8 is located outside the end part 25 of the lower electrode (second contact electrode (second ohmic electrode 18)). In this way, even if the light-emitting device structure 8 has a cutout 23, as long as the boundary part 24 between the cutout 23 and the outer side of the light-emitting device structure 8 is located outside the end part 25 of the lower electrode (second contact electrode (second ohmic electrode 18)), it can still sufficiently prevent the strength decrease. By preventing a strength decrease in this way, the frequency of dice cracking can be reduced.

### EXAMPLES

Hereinafter, the present invention will be described more specifically with reference to Examples and Comparative Examples. However, the present invention is not limited thereto.

### (Example 1)

After stacking a first conductivity-type GaAs buffer layer on a first conductivity-type GaAs starting substrate, an epitaxial wafer with a light emitting device structure was provided as an epitaxial functional layer in which the following were sequentially grown: a first conductivity-type GaₓIn₁₋ₓP (0.4≤x≤0.6) first etching stop layer of 0.1 µm thickness; a first conductivity-type GaAs second etching stop layer of 0.1 µm thickness; a first conductivity-type (Al_{y}Ga_{1-y})ₓIn₁₋ₓP (0.4≤x≤0.6, 0.6≤y≤1.0) first cladding layer of 1.0 µm thickness; a non-doped (Al_{y}Ga_{1-y})ₓIn₁₋ₓP (0.4≤x≤0.6, 0≤y≤0.5) active layer; a second conductivity-type (Al_{y}Ga_{1-y})ₓIn₁₋ₓP (0.4≤x≤0.6,0.6≤y≤1.0) second cladding layer of 1.0 µm thickness; a second conductivity-type GaₓIn₁₋ₓP (0.5≤x≤1.0) intermediate layer of 0.1 µm thickness; and a second conductivity-type GaP window layer of 6 µm thickness.

Next, benzocyclobutene (BCB) was spin-coated onto the epitaxial wafer as a thermosetting bonding material. Then, the epitaxial wafer was stacked facing the to-be-bonded wafer, i.e., the sapphire wafer, and bonded to it by thermal compression under a vacuum atmosphere. When BCB was coated on by spin coating, the designed film thickness was set to 0.6 µm.

Next, the GaAs starting substrate was removed by wet etching to expose the first etching stop layer, and the first and the second etching stop layers were then removed with appropriate etchants to expose the first cladding layer, thereby producing an epitaxial bonded substrate that retained only the DH layer and the window layer.

Next, a SiO₂ film was formed to a thickness of 1 µm on the EP bonded substrate by a P-CVD method using TEOS and O₂ as the materials. A resist pattern was formed by a photolitho method, and pattern shape of SiO₂ was made with a hydrofluoric acid solution. This SiO₂ pattern shape was 35 µm×55 µm square. Using the SiO₂ pattern as a hard mask, ICP treatment was performed with an ICP apparatus into which chlorine-based gas had been introduced, and the DH layer and a GaP layer were dry etched to expose the BCB layer. Then, the gas was switched to a CF-based one and the BCB layer was dry etched to form a device isolation pattern consisting of the DH layer and the GaP layer. After forming the device isolation pattern, a SiO₂ pattern was formed so that part of the device isolation pattern was open. Part of the DH layer was etched by the ICP method in the same manner as above to expose the second cladding layer, the intermediate layer, or the GaP layer. Then, processing was performed to provide it with a bathtub-shaped processed part.

After forming the bathtub-shaped processed part, an entire surface was coated with a SiO₂ layer 0.1 µm thick by a P-CVD method using TEOS and O₂ as materials, to form an insulating film.

A resist pattern was formed by a photolitho method so that both the bottom of the bathtub-shaped processed part, i.e., the second contact part, and part of the first cladding layer, i.e., the first contact part were open, and opening parts were formed by wet etching using a hydrofluoric acid-based etchant. The opening parts are the bottom of the bathtub-shaped processed part, i.e., the second contact part, and the first contact part where part of the first cladding layer is exposed.

After the opening processing, a first contact electrode was formed at the first contact part, and a second contact electrode was formed at the second contact part. These film thickness were formed to be 0.1 µm, which were substantially the same as that of the SiO₂ insulating film.

After the contact electrodes were formed, pad electrodes were formed in such a way that they were in contact with at least part of each contact electrode and the electrodes were separated electrically.

The micro-LED device pattern was pressed against a quartz substrate that had a silicone convex pattern similar to the micro-LED device pattern and pitch, and an excimer laser was shone on from the sapphire substrate side to sublimate the BCB. By doing so, the LLO step was performed to separate the micro-LED device from the sapphire, and the micro-LED device was transferred from the sapphire substrate to the quartz substrate.

### (Example 2)

In Example 2, a micro-LED device was manufactured under the same conditions as in Example 1, except that the device isolation pattern had two cutouts symmetrically arranged at corners as shown in FIG 10. Note that for a corner cutout, the length D shown in FIG. 10 was set to 2 µm.

### (Example 3)

In Example 3, a micro-LED device was manufactured under the same conditions as in Example 2, except that the length D was set to 0 µm.

### (Comparative Example 1)

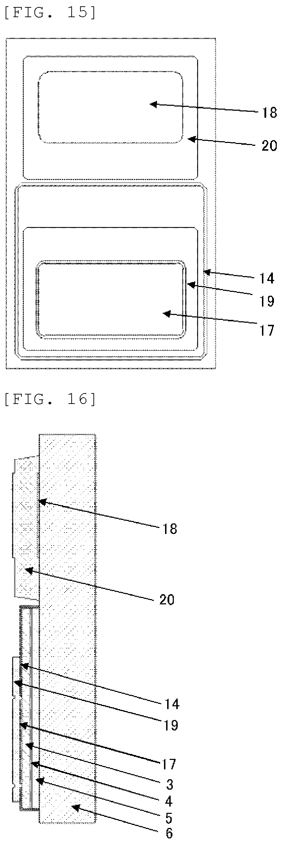

In Comparative Example 1, a micro-LED device was manufactured in which the second conductivity-type layer of the second cladding layer was processed to make it exposed, the same as in Example 1. However, instead of being processed to form a bathtub shape, the second conductivity-type layer was exposed all around the second contact electrode as shown in FIG 15 and FIG. 16. Apart from this, all the other conditions were the same as for Example 1.

### (Comparative Example 2)

In Comparative Example 2, a micro-LED device was manufactured under the same conditions as in Example 2, except that the length D was set to -2 µm.

### (Micro-LED device cracking situation in the Examples and Comparative Examples)

Table 1 shows the occurrence rate (%) of cracking in the micro-LED devices during the LLO process for Examples 1, 2, and 3 and Comparative Examples 1 and 2. As shown in Table 1, for Example 1, in which the light-emitting device structure surrounds the lower electrode continuously without any breaks, and for Examples 2 and 3, in which there are cutouts at corners and the boundary part between the cutout and the outer side of the light-emitting device structure is located outside the end part of the lower electrode (D≥0), the average cracking occurrence rate is 0 %. This is clearly a significant improvement over the average cracking occurrence rate (30%, 27%) of Comparative Example 1, which is a conventional structure in which there is no light-emitting device structure around the lower electrode, and Comparative Example 2, in which there are cutouts at corners, and the boundary part between the cutout and the outer side of the light-emitting device structure is located inside the end part of the lower electrode (D<0).

**[Table 1]**

| | Maximum value (%) | Minimum value (%) | Average value (%) |
|---|---|---|---|
| Example 1 | 1 | 0 | 0 |
| Example 2 | 1 | 0 | 0 |
| Example 3 | 1 | 0 | 0 |
| Comparative Example 1 | 46 | 17 | 30 |
| Comparative Example 2 | 38 | 14 | 27 |

It should be noted that the present invention is not limited to the examples described above. The examples described above are just examples, and any examples that have substantially the same features and demonstrate the same functions and effects as those in the technical concepts disclosed in the claims of the present invention are included in the technical scope of the present invention.

## Claims

1. A micro-LED device **characterized by** having:
one side less than 100 µm; and
a light-emitting device structure with an active layer comprised of (Al_{y}Ga_{1-y})ₓIn₁₋ₓP (0.4≤x≤0.6, 0≤y≤0.5) sandwiched between a first cladding and a second cladding; and having:
an upper electrode; and
a lower electrode of opposite polarity to the upper electrode; and being a micro-LED device wherein:
the light-emitting device structure, the upper electrode, and the lower electrode are placed on a first surface of the micro-LED device;
the upper electrode is placed on an upper surface of the light-emitting device structure;
the lower electrode is placed in a location where the light-emitting device structure is not present; and
the light-emitting device structure is placed so that it surrounds the lower electrode.

2. The micro-LED device according to Claim 1, wherein the light-emitting device structure surrounding the lower electrode either does so continuously without any breaks, or has a cutout, and a boundary part between the cutout and an outer side of the light-emitting device structure is located outside an end part of the lower electrode.

3. The micro-LED device according to Claim 2, wherein a transparent wafer to an emission wavelength is bonded to a second surface of the micro-LED device with an adhesive or a bonding material.

4. The micro-LED device according to Claim 3, wherein the adhesive or the bonding material is BCB.

5. The micro-LED device according to Claim 3 or 4, wherein the transparent wafer is made of sapphire or quartz.
